(19) Europäisches Patentamt
European Patent Office
Office européen des brevets

(11) EP 4 354 158 A1

(12) EUROPEAN PATENT APPLICATION

(43) Date of publication:
17.04.2024 Bulletin 2024/16

(21) Application number: 22306552.5

(22) Date of filing: 13.10.2022

(51) International Patent Classification (IPC):
G01R 29/08 (2006.01)    G01N 25/72 (2006.01)

(52) Cooperative Patent Classification (CPC):
G01R 29/0857; G01R 29/0892; G01N 25/72

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicants:
• Université de Rennes
  35042 Rennes (FR)
• Centre national de la recherche scientifique
  75016 Paris (FR)
• Institut National des Sciences Appliquées de
  Rennes
  35708 Rennes Cedex 7 (FR)

• Nantes Université
  44000 Nantes (FR)
• CentraleSupélec
  91190 - Gif sur Yvette (FR)

(72) Inventors:
• BORYSKIN, Artem
  35235 THORIGNE FOUILLARD (FR)
• ZIANE, Massinissa
  35700 RENNES (FR)
• SAULEAU, Ronan
  35690 ACIGNE (FR)
• ZHADOBOV, Maxim
  35700 RENNES (FR)

(74) Representative: Plasseraud IP
  66, rue de la Chaussée d'Antin
  75440 Paris Cedex 09 (FR)

(54) **METHOD FOR MEASURING AND PROCESSING OF THERMOGRAPHY DATA**

(57)    Method for retrieving a useful signal from a bulk response signal emitted by a target subjected to an excitation signal, comprising:
- providing a first excitation signal (3a, 3b, 3c) at least modulated at a frequency $F_{lock}$ during a first period of time (t1) corresponding to a transient mode of a response signal and causing a first bulk response signal (4a, 4b, 4c) and recording said first bulk response signal,
- calculating a first Fourier transform $FT\{\Delta T(t)\}$ (10a, 10b, 10c) of said bulk response signal in response to said first excitation signal during said first period to provide a first spectrum of an exponential term ($f_e(\omega)$) (5a, 5b, 5c) a first spectrum of ambient noise ($f_n(\omega)$) (7) and a first spectrum of a useful signal ($f_p(\omega)$) (6a, 6b, 6c) in said first measured bulk response signal,
- extracting said first spectrum of a useful signal ($f_p(\omega)$) (6a, 6b, 6c) through removing said first spectrum of the exponential term ($f_e(\omega)$) (5a, 5b, 5c) from said first Fourier transform

FIG. 3B

## Description

### Technical filed

The present disclosure relates to methods for processing thermography data and, more specifically thermography data resulting from exposure of a target with a low power electromagnetic source for instance in metrology or dosimetry or quality control measurements.

### Background

When analysing signals of small amplitudes that are buried in noise and other signal disturbances with amplitudes that might be comparable or even higher than the signal of interest itself, a post-processing technique, known as "lock-in", can be used. Its basic principle consists in modulating the excitation signal with time period Tlock and with a specific waveform, such as sine, square, etc. Its implementation requires modulated excitation with a predetermined waveform and periodicity. The Fourier theory can be used to transform the measured signals from the time domain to the spectral domain and then to remove the noise spectral components from the measured spectrum thus filtering the useful spectral component of the periodic excitation at the lock-in frequency.

To be efficient, the lock-in technique is usually applied in the steady state (or at least quasi steady state) mode because in this case the spectrum of the continuous component of the signal is localized near zero frequency, facilitating the efficient filtering. The "position" of the lock-in spectral component in the frequency domain can be tuned on demand by varying the lock-in frequency.

However, in many real-life scenarios the steady state can only be achieved after a long period of time, typically tens of minutes and up to several hours, which can be prohibitively long for certain applications because it restricts the throughput of the entire production/characterization cycle.

In particular, this is often the case for multi-physics problems that involve energy transformation from one form to another, such as, for example, electromagnetic to thermal energy conversion. The latter is often associated with the relatively high thermal noise level and long delay needed to reach the steady state equilibrium because of the thermal conductivity of all the materials and host medium. In this case, long acquisition time may also suffer from the environmental temperature drift and undesired heat spread.

A specific practical example of a device that can suffer from the aforementioned problem is an electromagnetic (hereafter EM) waves measurement system where the EM metrics are retrieved from temperature dynamics measurements. Such systems are often used for characterization of antennas and wireless devices.

More specifically, such systems rely on using thermal sensors, e.g., infrared imaging sensors, for measuring heat patterns induced by absorbed EM energy in a screen, such as a thin lossy dielectric film, exposed to the EM radiation emitted by a wireless device under test. In case of portable wireless devices, such as smartphones or tablets, operating at the maximum power, typically ranging from tens to hundreds of mW, the corresponding temperature rise in the 0.1 to 1°C range may be induced after a short exposure, e.g., shorter than several minutes. Such temperature rise may be comparable with fluctuations of the ambient temperature representing the noise level. The traditional ways to overcome this problem comprise:

**[0008]** - Increasing the exposure time and therefore the useful signal level: Indeed, a larger temperature rise, e.g., above 1°C, can be reached after a longer exposure duration, e.g., above several minutes. However, longer exposure provokes another important problem related to the heat spread in the plane of the screen that disturbs the heat pattern, mainly in enlarging the heated zone and smoothening the pick values, thus resulting in a poor correlation between the measured heat pattern and the initial EM field distribution representing the heat source.

**[0009]** - Applying a lock-in method with a modulated excitation and noise filtering in the Fourier domain in steady state condition, whose achievement may require even longer period of time, up to several hours.

It shall also be noted that measurement procedures in metrology often require repeated tests, considering different antenna configurations and/or relative position of the wireless device with respect to the target. The time needed to reach the steady state in heating and then in cooling before starting a new test becomes prohibitively long.

In consequence, there is always a trade-off between the exposure and signal acquisition duration, signal level, accuracy and signal to noise ratio (SNR) of the postprocessing procedure that is affected by the heat spread phenomenon.

In view of the above problems, there is a strong need for methods that would allow fast and reliable measurements of low-amplitude signals in the transient mode e.g., without waiting for reaching a steady state.

### Summary

An important feature of the present disclosure consists in achieving measurements on a target using the lock-in technique during an initial transient phase of a signal in response to an excitation signal received by the target.

More particularly, the present disclosure concerns a method for retrieving a useful signal from a bulk response signal emitted by a target subjected to an excitation signal, comprising:

a. - providing a first excitation signal at least modulated at a frequency $F_{lock}$ during a first period of time corresponding to a transient mode of a response signal and causing a first bulk response signal and recording said first bulk response signal,

b. - calculating a first Fourier transform $FT\{\Delta T(t)\}$ of said bulk response signal in response to said first excitation signal during said first period to provide a first spectrum of an exponential term ($f_e(\omega)$) a first spectrum of ambient noise ($f_n(\omega)$) and a first spectrum of a useful signal ($f_p(\omega)$) in said first measured bulk response signal,

c. - extracting said first spectrum of a useful signal ($f_p(\omega)$) through removing said first spectrum of the exponential term ($f_e(\omega)$) from said first Fourier transform.

In a first embodiment, said first excitation signal may be followed with a further signal in a second period of time, and said method may comprise further:

a. - providing said second period of time with a first sub-period of time where said further signal comprises a null excitation signal value to let said bulk response signal end and a second sub period of time where said further signal comprises a constant power excitation signal having a power value equal to the mean power of said first signal during said first period,

b. - calculating a second Fourier transform $FT\{\Delta T(t)\}$ of a second measured bulk response signal in response to said constant power excitation signal in said second sub-period to provide a second spectrum of said exponential term ($f_e(\omega)$), in said second measured bulk response signal,

c. - subtracting said second spectrum of said exponential term ($f_e(\omega)$) from said first spectrum of said exponential term ($f_e(\omega)$) in said first Fourier transform $FT\{\Delta T(t)\}$ for removing said first spectrum of the exponential term ($f_e(\omega)$) from said first Fourier transform and extracting the first spectrum of the useful signal ($f_p(\omega)$).

In a second embodiment, the method may comprise further:

a. - modulating said first excitation signal with a non-periodic envelope during said first period of time wherein said non-periodic envelope comprises a positive skew distribution during said first period of time, said positive skew distribution being adapted to have said bulk signal comprising a non-periodic Gaussian-like shape in order that said first spectrum of said exponential term ($f_e(\omega)$) does not overlap said third spectrum of said useful signal ($f_p(\omega)$),

b. and

c. - filtering said first spectrum of said exponential term ($f_e(\omega)$) in said first Fourier transform for removing said first spectrum of the exponential term ($f_e(\omega)$) from said first Fourier transform and extracting the first spectrum of the useful signal ($f_p(\omega)$).

In a third embodiment the method may comprise:

a. - reconstructing by interpolation of a non-periodic part of the bulk response signal after provision of said first excitation signal power modulated at a frequency $F_{lock}$ during a first period of time corresponding to a transient mode of said bulk response signal,

b. - calculating a third Fourier transform $FT\{\Delta T(t)\}$ of said non-periodic part to provide a third spectrum of an exponential term ($f_e(\omega)$),

c. - subtracting said third spectrum of said exponential term ($f_e(\omega)$) from said first spectrum of said exponential term ($f_e(\omega)$), said spectrum of a useful signal ($f_p(\omega)$) in said first Fourier transform $FT\{\Delta T(t)\}$ for removing said first spectrum of the exponential term ($f_e(\omega)$) from said first Fourier transform and extracting the first spectrum of the useful signal ($f_p(\omega)$).

The method may comprise an inverse Fourier transform to provide said useful signal ($f_p(\omega)$) after extracting the

first spectrum of the useful signal ($f_p(\omega)$).

The method may further comprise a retrieval of a quantitative characteristic of the EM field incident on or absorbed by the target based on said useful signal and said first excitation signal.

The excitation signal may be one of electromagnetic waves such as microwave, mm-wave, IR, visible, or UV light generated by an electromagnetic source such as a wireless communication device, an EM power generator, a lamp, a laser or a heater or their combination.

Said excitation signal may also be a heat wave generated by a heat source driven by an electrical or mechanical force.

The bulk response signal may be a time-variable physical quantity relative to the heat generated by a medium of the target when exposed to said excitation signal such as:

   a. - an intensity of an IR radiation generated by said medium in response to said excitation signal, or

   b. - an amplitude and/or frequency variation of an emitted or reflected light by a material of the target such as a thermosensitive material, such as liquid crystal or a phase change material including chalcogenide glass or vanadium dioxide in response to said excitation signal; or

   c. - a voltage generated by a thermocouple attached or embedded in said medium of the target.

Emission of said excitation signal is preferably stopped before a thermal steady state condition (SS) of the target is reached.

The method preferably comprises filtering the ambient noise ($f_n(\omega)$) in the time or frequency domain to suppress the ambient noise from the useful signal ($f_p(\omega)$).

The present disclosure also concerns a system for performing the method of the disclosure, such system comprising a source of excitation signal, in said source means to modulate a power of said excitation signal at a frequency $F_{lock}$, a target providing a bulk response signal when subjected to said excitation signal, sensor means for acquiring said bulk response signal, analog to digital conversion means and computer means configured to process said recording, reconstructing, calculating and subtracting on digital data representative of bulk response signals converted by said analog to digital conversion means.

Said source may comprise means to modulate a power of said excitation signal with a periodic or non-periodic envelope.

Said target may have a 3D structure comprising at least one layer of a lossy dielectric medium made of an organic or inorganic insulating material or semiconductor material. In this regard, lossy is in the sense that this medium can actually absorb the EM radiation at the frequency of the excitation signal. This ability for EM field absorption is quantitively defined by the value of the imaginary part of the complex dielectric permittivity. Alternatively, I can be defined by the loss tangent (i.e. ratio of the imaginary and real parts of the complex dielectric permittivity).

The source of excitation signal may be a wireless communication device and the target may be a test object subject to EM radiation of said wireless communication device, said sensor is an IR sensor measuring intensity of the IR radiation, which is proportional to the temperature of the object being a source of this IR radiation.

The system may further comprise communication means between said source of excitation signal and said computer means for scheduling emission of said excitation signal and acquiring said bulk response signal.

### Brief description of the drawings

A detailed description of exemplary embodiments of the invention will be discussed hereunder in reference to the attached drawings where:

   Figure 1A shows a typical heat dynamics at a surface of an object made of a lossy dielectric exposed to non-ionizing electromagnetic radiation under exposure with a constant in time incident power density;

   Figure 1B shows typical heat dynamics at a surface of an object made of a lossy dielectric exposed to non-ionizing electromagnetic radiation modulated by a temporal sequence of periodic pulses;

   Figure 1C shows representation of Fourier spectrum of temperature rise dynamics in a transient regime TR part of figure 1B;

   Figure 1D shows representation of Fourier spectrum of temperature rise dynamics in a steady state regime SS part of figure 1B;

Figure 1E shows a curve of an extracted useful signal from a bulk response signal;

Figure 2 shows a power modulated excitation signal curve according to a first embodiment of the present disclosure;

Figure 3A shows the temperature elevation resulting from the signal curve of figure 2;

Figure 3B shows the spectrums in a first part and third part of figure 2 and a resulting spectrum curve after subtraction;

Figure 4A shows a power modulated excitation signal curve according to a second embodiment of the present disclosure;

Figure 4B shows a decomposition of the curve of figure 4B;

Figure 5A shows a resulting bulk response signal from the power curve of figure 4;

Figure 5B shows the spectrum of the curve of figure 5A;

Figure 6A shows an excitation signal that consist of a periodic ON / OFF signal and non-periodic signal and resulting bulk response signal curve used in a third embodiment;

Figure 6B shows the resulting curve with interpolated non-periodic component extracted from the bulk response signal curve of figure 6A;

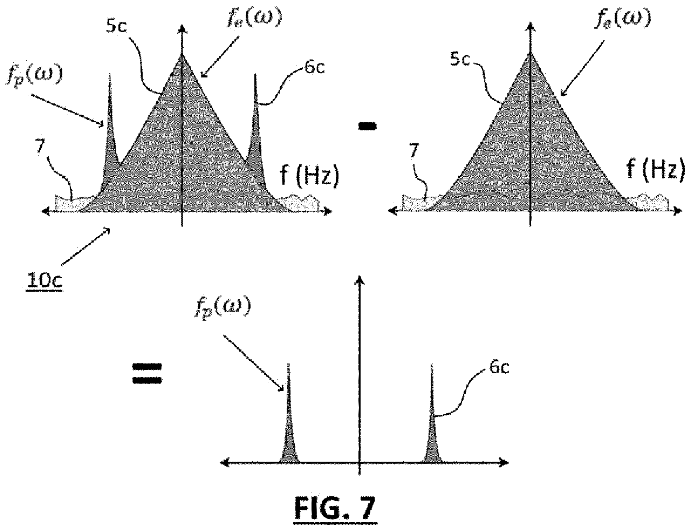

Figure 7 shows a reconstruction of a spectrum of a useful signal in the third embodiment.

Figure 8 shows a schematic perspective view of a first example of a system in accordance with the present disclosure;

Figure 9 shows a schematic perspective view of a second example of a system in accordance with the present disclosure.

**Detailed description of embodiments**

In the following, the proposed method is illustrated referring to an example of practical application in EM measurements, where it can be beneficially used for post-processing of heat patterns induced by EM field radiated by low-power wireless devices. However, it is to be understood that the proposed method of transient lock-in is not limited to this application and can be applied for post-processing of any analytical or experimental data related to a thermo-dynamic system with a heat source represented by an EM loss (without limitations on the frequency range, which can be for example low frequency, microwave, mmWave, THz or optical) or any other heat source (e.g., electrical, magnetic, mechanical).

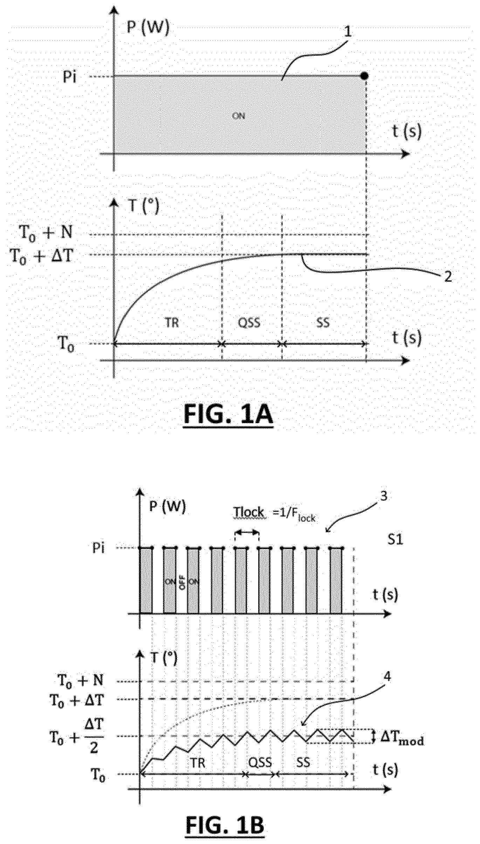

Figures 1A illustrates typical heat dynamics 2 of an object exposed to EM radiation 1 emitted by a spatially localized EM source. Such a source can be for instance represented by a smart phone or any other wireless device, referred hereafter as Device Under Test (DUT). The object made of a lossy dielectric exposed to non-ionizing electromagnetic radiation under exposure with a constant in time incident power density where lossy means that the dielectric can actually absorb the EM radiation at the frequency of the excitation signal. This ability for EM field absorption is quantitively defined by the value of the imaginary part of the complex dielectric permittivity. Alternatively, it can be defined by the loss tangent (i.e. ratio of the imaginary and real parts of the complex dielectric permittivity).

In case of exposure of a target with a constant in time incident power density 1 as depicted in figure 1A, a rapid growth of the temperature, in other words high temperature rise rate as for a given source typical dT/dt threshold can be expressed as a function of the absorbed power density, is observed during the initial time period that may last from several seconds to several minutes. For such exposure durations, the heat spread in the target can be neglected, and the heat distribution is linearly proportional to the absorbed power density. The absolute value of the absorbed power density and / or specific absorption rate (hereafter SAR) can be for instance retrieved using the SAR $\Leftrightarrow$ T relationship (1) when the duration tends towards 0 s or using a parametric solution of the heat transfer equation for the object under test for longer durations. This phase is referred hereafter as transient (hereafter TR) phase, to be distinguished from the steady-state phase when a relatively small or no further average temperature growth is observed. Note that in the steady-state the distribution of the temperature rise and absorbed power density can be substantially different.

$$\left.\frac{dT}{dt}\right|_{t=0} = \frac{1}{c}SAR, \qquad\qquad (1)$$

where c is the thermal specific heat of the exposed object.

During the initial time period, the heat spread from the heated zone can be considered as negligible because of a low temperature gradient and relatively long time constant of the heat diffusion. With time, the temperature increases as well as the heat spread from the exposed zone. The heat rate (dT/dt) becomes slower, so the temperature tends to an asymptotic value of T0 + $\Delta$T, where T0 is the baseline temperature (e.g., ambient temperature) and $\Delta$T is the steady-state temperature increase. This phase can be referred hereafter as quasi-steady state (hereafter QSS). As soon as the equilibrium condition is achieved with the input power balanced by the thermal loss associated with the heat spread and thermal radiation, no further temperature growth is observed. This condition is commonly referred as the steady state (hereafter SS).

In case of a pulsed excitation by an amplitude-modulated signal 3 as shown in figure 1B with a predetermined amplitude Pi and frequency $F_{lock}=1/T_{lock}$, the TR, QSS, and SS phases can be identified similarly for the average temperature rise as in the case of a non-modulated exposure.

In practice, measurement of the heat dynamics that can be used to retrieve EM metrics, can be substantially complicated by the thermal noise. Measurement of the response signal (i.e., the temperature increase $\Delta$T(t) induced by the absorbed EM power) can be difficult or even impossible if the thermal noise level N(t) is comparable or exceeds the temperature increase in steady state ($N \geq \Delta Tmax$). Indeed, under this condition the response signal is buried by the thermal noise as in figure 1A which makes a bulk response signal.

The present disclosure is using the fact that although the same is also true in case of a modulated excitation signal 3 in figure 1B, the response signal can still be retrieved when a steady state SS is reached using the frequency-domain lock-in approach, based on the Fourier transformation theory, as described below.

To illustrate the lock-in approach, let's consider the temperature rise as a sum of the response signal s(t) and noise N(t):

$$\Delta T(t) = s(t) + N(t); \qquad\qquad (2)$$

The response signal s(t) 4 can then be represented as a sum of a "non-periodic" and "periodic" associated with the increase of the average temperature and with the oscillating part, respectively.

In a simplistic embodiment, the non-periodic part can be approximated by a function that can be locally approximated by a linear function, while the oscillating part can be represented by a periodic function (e.g., by a sin), leading to the following expression:

$$\Delta T(t) \approx A(1 - e^{-Bt}) + C\sin(\omega_0 t) + N(t). \qquad\qquad (3)$$

where A, B, and C are constants selected to fit the thermal dynamics at time instant t, that depends on the thermal properties of the object medium and its formfactor, as well as on the heat source type and power (which are the parameters that define the heat spread from the local heated zone).

Note that in the steady state SS, the first term tends to constant value "A". It also tends to constant value "A" in the quasi steady-state QSS mode but with a certain degree of accuracy that depends on the relation between the first and the second terms. However, in the transient TR mode, the first term is variable and must be taken into account as it is time dependent and therefore its spectrum is non-zero.

The Fourier transformation applied to the temperature rise signal will give three terms in the spectral domain, corresponding to the exponential (evanescent with frequency) $f_e(\omega)$, periodic (narrowband) $f_p(\omega)$, and noise (broadband) components $f_n(\omega)$ 7:

$$FT(\Delta T(t)) = f_e(\omega) + f_p(\omega) + f_n(\omega). \qquad\qquad (4)$$

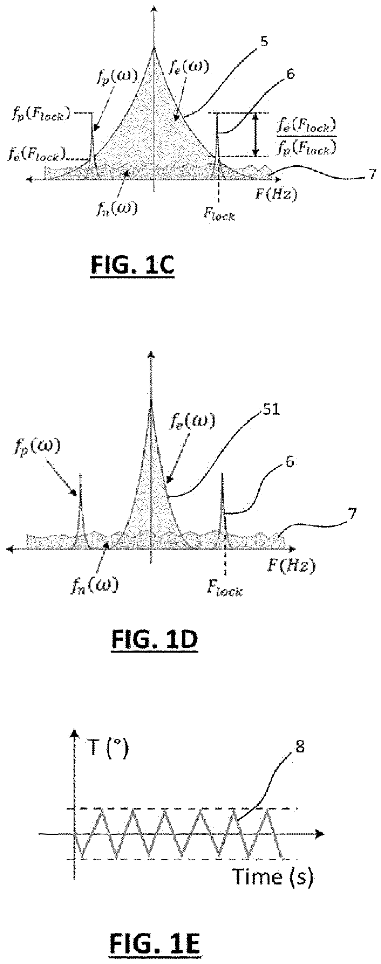

Figures 1C and 1D illustrate a typical shape of these spectral components in the frequency domain. Thermal noise 7 can be represented by white Gaussian noise. The spectral level of noise ($\hat{N}$) is inversely proportional to the square root of the integration time (IT) (i.e., acquisition duration) and sampling frequency (number of measurement points per second) (Fs) and can be estimated as follows:

$$\hat{N} \approx \int_{-\infty}^{+\infty} |f_n(\omega)| df / \sqrt{IT \cdot Fs}. \tag{5}$$

The periodic term 6 is represented by a narrow spectral component around $F_{lock} = \omega_0$ and expressed as follows:

$$f_p(\omega) = \frac{\Delta T_{mod}}{2} \left( \delta(\omega - \omega_{lock}) + \delta(\omega + \omega_{lock}) \right), \tag{6}$$

where $\delta$ is the Dirac delta impulse function, $\Delta T_{mod}$ is the amplitude of temperature oscillation at steady state in figure 1B. Its position along frequency axis can be controlled through the amplitude modulation of the absorbed power density.
Finally, the exponential term 5, is a wide evanescent spectral component that can partially overlap the narrow $F_{lock}$ spectral component related to the response periodic signal. The width and amplitude of the wide component are defined by the Fourier transform of the exponential term given as follows:

$$f_e(\omega) = \Delta T (\pi \delta(f) + \frac{1}{j2\pi f} - \frac{1}{B + j2\pi f}), \tag{7}$$

In figures 1C and 1D, the narrow spectral component at $F_{lock}$ 6 corresponds to the periodic amplitude modulation signal with amplitude $\Delta T_{mod}/2$ and remains the same in both regimes. On the contrary, the bandwidths of the spectral component related to the average rise of temperature are different in the transient and steady state regimes. In the steady state regime of figure 1D, the spectrum 51 of the average temperature rise component is narrowband and centred around the zero frequency and thus can be easily filtered. In the transient mode in figure 1C, the spectrum 5 of the average temperature rise component is wider leading to an overlap between the narrow spectral component related to the amplitude-modulated signal at $F_{lock}$ that complicates distinguishing these two spectral components. This overlapping introduces errors on the retrieval of the absolute value of the temperature rise ($\Delta T_{mod}$), hence the absorbed power density or SAR. This explains why the steady state condition is used in the lock-in technique.
Hereafter, we refer to the spectrum that corresponds to the average temperature rise as parasitic spectrum.
To retrieve the absorbed power density or specific absorption rate, hereafter SAR, from the measured temperature dynamics, the following steps and conditions are to be fulfilled:

a. The excitation signal is modulated in time at frequency $F_{lock}$,

b. The Fourier transform of the acquired temperature signal is calculated (i.e., $FT\{\Delta T(t)\}$),

c. Bandpass filter is applied at $F_{lock}$ to filter the spectrum of the exponential term ($f_e(\omega)$) and ambient noise ($f_n(\omega)$) from the response signal ($f_p(\omega)$),

d. applying an inverse Fourier transformation to $f_p(\omega)$ the useful signal to determine the temperature rise,

e. Calculating the power density or SAR using said temperature rise.

We define the following two figures of merit SNR and SPR referring to signal to noise ratio and signal to parasitic spectrum (e.g., spectrum of exponential rise of temperature) ratio. The first quantifies the difference between the amplitude of temperature oscillation and noise, whereas the second describes how $f_p(\omega)$ overlaps with the $f_e(\omega)$:

$$SNR = \frac{\Delta T_{mod}}{N} \tag{8.a}$$

$$SPR = \frac{f_p(\omega)}{f_e(\omega)} \tag{8.b}$$

Conventional lock-in method is implemented at steady-state where the spectral image of the heat dynamics corresponds to a superposition of the quasi-static part represented by a narrow band spectrum 51 around F=0 Hz and periodic part with a frequency $F=F_{lock}$ 6, respectively as in figure 1D. The parasitic spectrum related to average rise of temperature and the thermal noise are then removed by filtering of $F_{lock}$. The spectrum at $F_{lock}$ equals only to $f_p(F_{lock})$, i.e., $\Delta T_{mod}/2$ (6), which is related to power density or SAR as given in (1).

In the transient state, lock-in thermography becomes less efficient as the heat dynamics is represented by the superposition of the continuous increase of temperature with a periodic variation, which results in a broadband spectrum ($f_e(\omega)$) 5 around 0 Hz that overlaps with the narrowband spectrum of the useful signal ($f_p(\omega)$) 6 at $F=F_{lock}$ as in figure 1C. Thus, it is difficult to distinguish between the spectrum corresponding to the periodic part of the excitation signal and the one corresponding to the average temperature rise. Unlike steady state where the spectrum at $F_{lock}$ equals to $f_p(F_{lock})$, in transient state it equals to the sum of $f_p(F_{lock})$ and $f_e(F_{lock})$.

This aliasing between $f_p(\omega)$ and $f_e(\omega)$ introduces errors in the retrieved power density, 2-dimentionnal (2D) distribution and absolute value. This makes difficult to use of lock-in thermography in transient state to retrieve power density.

An idea would be to shift the useful spectrum $f_p(\omega)$ towards higher frequencies by increasing $F_{lock}$ in order to mitigate its overlapping with $f_e(F_{lock})$, hence increase the SPR. However, increasing $F_{lock}$ implies reduction of exposure duration at each lock-in period, thus it reduces the amplitude of temperature oscillations ($\Delta T_{mod}$), which finally results in drastic decrease of the SNR ($\Delta T_{mod}/N$) and does not solve the problem.

To improve the efficiency of the lock-in technique in transient phase, i.e. use of lock-in in transient phase to speed up measurements while guarantying a sufficiently high SPR and SNR that allows an accurate retrieval of power density, the present disclosure proposes the transient lock-in solution which comprises two main types of processes:

- Reconstructing $f_e(\omega)$ separately from $f_p(\omega)$ using adapted signals as in embodiment 1 and embodiment 2 or

- an advanced post processing technique as in embodiment 3 hereunder. Then if $f_e(\omega)$ is known, $f_p(\omega)$ can be distinguished from the superposition of $f_p(\omega)$ and $f_e(\omega)$.

In addition, to obtain the periodic response signal in the time domain, Reshaping of $f_e(\omega)$ in the frequency domain is done in such a way that the ratio $f_p(F_{lock})/f_e(F_{lock})$ is as small as possible (depending on the constraints of the SPR).

In consequence, a basis of the present disclosure transient lock-in method consists in either filtering the wideband parasite spectrum present in the transient regime or in reshaping it to mitigate its aliasing with the useful signal. Some of these embodiments can be combined to have a better efficiency in terms of speedup and/or accuracy. This allows one to use lock-in in transient phase to accurately retrieve the EM power density thanks to filtering techniques used to remove the ambient noise and parasitic spectrum related to the average increase of temperature.

We present hereafter different embodiments of the proposed transient lock-in technique that allows to measure low-amplitude signals buried in the noise (by improving SNR), minimizing the impact of the heat spread (by improving SPR), while simultaneously reducing the exposure duration (use of transient phase). Additionally, this allows to remove the sources of uncertainties related to the heat spread from the DUT to the object under test by heat conduction or convection, environmental temperature drift, and variations of received RF signal level.

To summarize, the method of the present disclosure comprises first a method for retrieving a useful signal 8 as shown in figure 1E from a bulk response signal 4 as in figure 1B emitted by a target subjected to an excitation signal 3, comprising:

    a. - providing a first excitation signal 3a, 3b, 3c at least modulated at a frequency Flock during a first period of time corresponding to a transient mode of a response signal causing a first bulk response signal 4a, 4b, 4c and recording said first bulk response signal,

    b. - calculating a first Fourier transform $FT\{\Delta T(t)\}$ 10a, 10b, 10c of said bulk response signal in response to said first excitation signal during said first period to provide a first spectrum of an exponential term ($f_e(\omega)$) 5a, 5b, 5c, a first spectrum of ambient noise ($f_n(\omega)$) 7 and a first spectrum of a useful signal ($f_p(\omega)$) 6a, 6b, 6c in said first measured bulk response signal,

    c. - extracting said first spectrum of a useful signal ($f_p(\omega)$) 6a, 6b, 6c through removing said first spectrum of the exponential term ($f_e(\omega)$) 5a, 5b, 5c from said first Fourier transform.

In addition to the process, a step of filtering the ambient noise may be done.

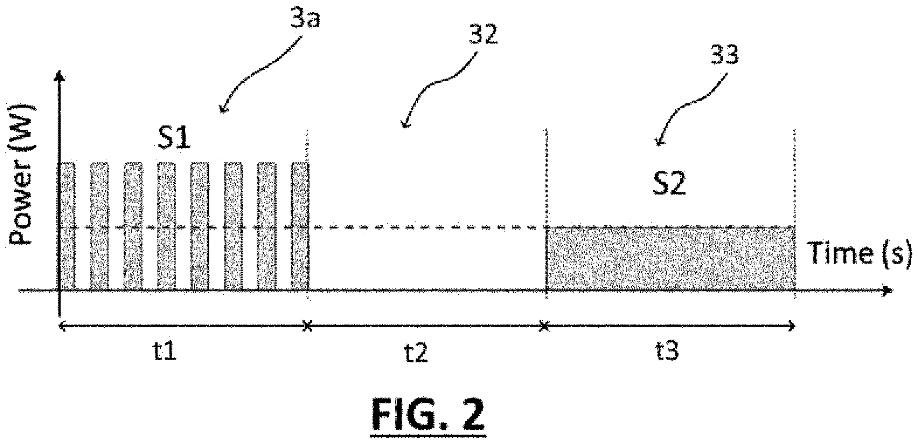

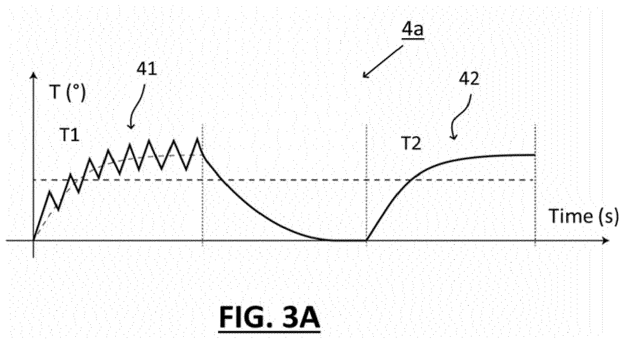

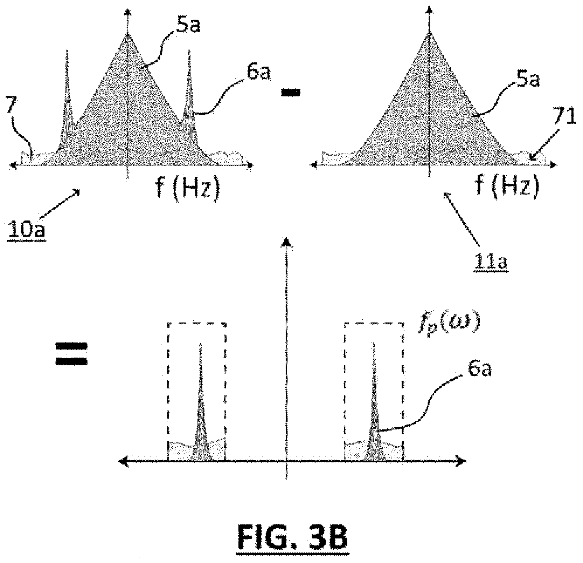

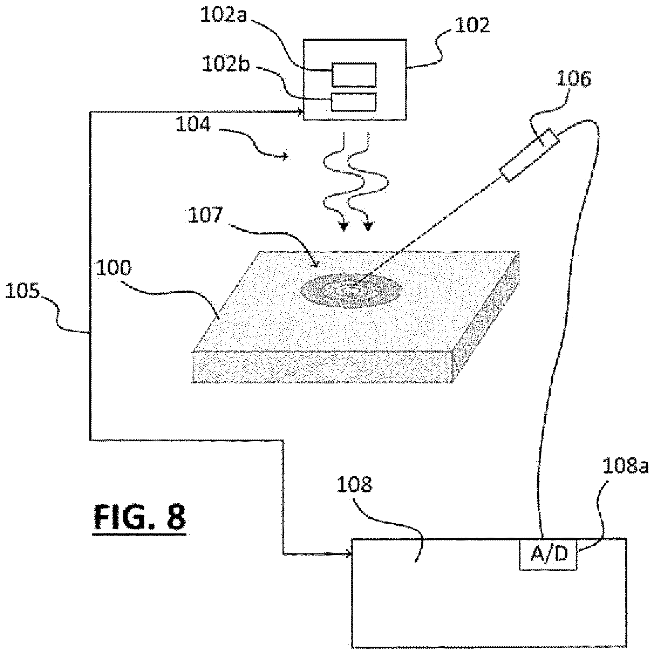

A first embodiment makes use of a specific excitation signal 3a that consist of a sequence of a first sub-signal S1 3 made of a periodic modulated wave at $F_{lock1}$ during t1 and a non-modulated ($F_{lock2} = 0$ Hz) sub-signal S2 33 during t3 separated by a zero signal 32 during t2. The spectrum of the recorded temperature at $F_{lock2}$ = 0 Hz is used to de-embed the quasi-exponential part of the temperature rise resulting from measurement at a non-zero lock-in frequency (i.e., periodic signal at $F_{lock1}$). The averaged power of the periodic signal should be equal to one of signal at $F_{lock2}$ = 0 Hz at every period $T_{lock}$. This embodiment allows to use efficiently lock-in at transient state, thus reducing measurement time, and benefit from the advantages of lock-in in steady state, i.e., improvement of SNR compared to measurement from continuous-wave signal. An example of such embodiment is given in figure 2 and figures 3A and 3B, transient lock-in is implemented employing a specific input power waveform consisting of two sub signals S1 and S2 as described in figure 2. S1 is periodic with a period $T_{lock}$, amplitude $\Delta P_1$, offset $P_1^{DC}$, and duration t1. S2 is continuous with magnitude $P_2^{DC}$ and duration t3. The power generator 102 is switched off for duration t2 to allow the cooling of the exposed object (e.g., screen, human skin equivalent model, etc. 100 - as exemplified in Figure 8. The curves T1 41 and T2 42 are temperature rise curves resulting from said sub-signals S1 and S2, respectively. In figure 3B, the useful spectral component $f_p(F_{lock})$ 6a is de-embedded from the spectrum of T1 10a by subtracting the spectrum of T2 11a from the spectrum of T1 10a. This is feasible if the following conditions are satisfied:

$$\int_{T_{lock}} S_1(t)dt \approx \Upsilon \int_{T_{lock}} S_2(t)dt, \qquad i.e, \qquad P_1^{DC} \approx \Upsilon P_2^{DC} \qquad (9.a)$$

and

$$t_1 \approx t_2 \qquad\qquad (9.b)$$

where $\Upsilon$ is a linear coefficient ($\Upsilon$ < 0). Furthermore, $\Delta P_1$ is up bounded by the maximum input signal power.

In this embodiment, lock-in is performed in the transient state thanks to the proposed method that allows to filter the parasitic spectrum related to the averaged exponential increase of the temperature signal (i.e., $f_e(\omega)$) and consequently retrieve the useful signal ($f_p(\omega)$). In this embodiment, the acquisition time is significantly reduced compared to conventional lock-in applied in steady-state where the thermal equilibrium should be reached. Furthermore, the SNR and SPR are significantly improved compared to measurement technique using periodic excitation with such a method and are improved by at least a factor of 2 compared to measurement conventional lock-in such as periodic excitation.

To summarize, in this embodiment, said first excitation signal 3a is followed with a further signal in a second period of time t2, t3, and the method comprises:

- providing said second period of time with a first sub-period of time t2 where said further signal comprises a null excitation signal 32 value to let said bulk response signal return to ambient (meaning that the temperature of the target has returned to the level of the temperature at the beginning of the first time interval) and a second sub period of time t3 where said further signal comprises a constant power excitation signal 33 having a power value equal to the mean power of said first signal during said first period,
- calculating a second Fourier transform $FT\{\Delta T(t)\}$ 11a of a second measured bulk response signal in response to said constant power excitation signal in said second sub-period to provide a second spectrum of said exponential term ($f_e(\omega)$) 5a, a second spectrum of ambient noise ($f_n(\omega)$) 71 in said second measured bulk response signal,
- subtracting said second spectrum of said exponential term ($f_e(\omega)$) 5a, from said first spectrum of said exponential term ($f_e(\omega)$) 5a) in said first Fourier transform $FT\{\Delta T(t)\}$ for removing said first spectrum of the exponential term ($f_e(\omega)$) 5a from said first Fourier transform and extracting the first spectrum of the useful signal ($f_p(\omega)$) 6a.

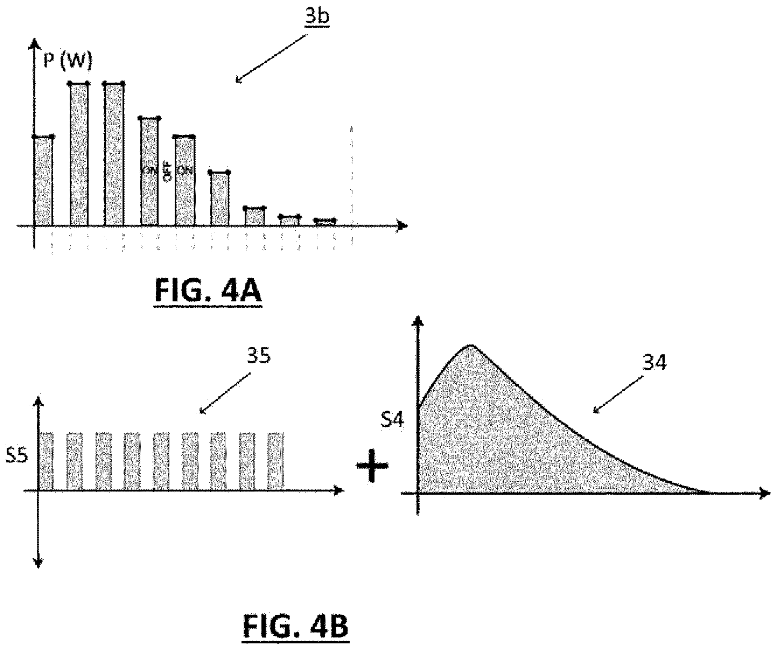

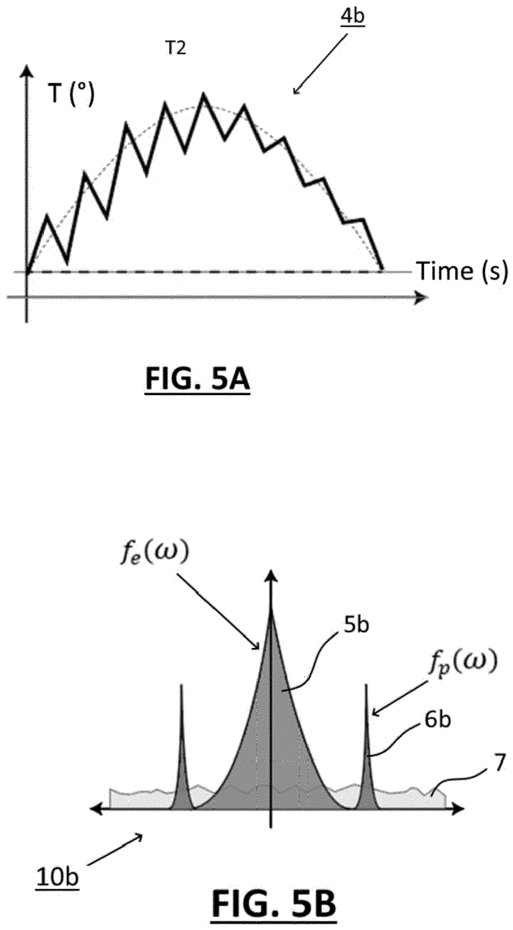

A second embodiment depicted in figure 4A uses an excitation signal 3b combining a periodic excitation signal power modulated at frequency $F_{lock}$ 35 and a specific non-periodic signal 34 shown in figure 4B to provide the excitation signal of figure 4A. The non-periodic signal 34 results in a narrow band spectrum having low spectral component at $F_{lock}$, thus, it doesn't overlap with the beneficial spectral component at $F_{lock}$. This embodiment allows to use efficiently lock-in at transient state, thus reducing measurement time, and benefit from the advantages of lock-in in steady state. The superposed periodic signal S5 35 and non-periodic signal S4 34 needs to have the particularity that the amplitude of its spectrum at $F_{lock}$ should be as low as possible compared to spectral component S5 (e.g., $f_p(F_{lock})/f_e(F_{lock})$ < 0.1 depending on the acceptable accuracy). Then the resulting bulk signal 4b represented in figure 5A is such that the non-periodic signal spectrum 5b in figure 5B after the Fourier transform does not recover part of the useful spectrum $f_p(F_{lock})$

6b allowing to retrieve such useful spectrum and signal applying a bandpass filter at $F_{lock}$.

In the given example, the non-periodic part of the excitation signal is modulated so that the temperature 4b takes a Gaussian like shape with time in figure 5A. Here, the larger the width of the Gaussian curve in time is, the narrower its spectrum would be and, consequently, the lower the overlapping between $f_p(\omega)$ and $f_e(\omega)$ at $F_{lock}$.

To summarize, in this embodiment, the method comprises:

- modulating said first excitation signal 35 with a non-periodic envelope 34 during said first period of time wherein said non-periodic envelope 34 comprises a positive skew distribution during said first period of time, said positive skew distribution being adapted to have said bulk signal comprising a non-periodic gaussian shape 4b in order that said first spectrum of said exponential term ($f_e(\omega)$) 5b does not overlap said third spectrum of said useful signal ($f_p(\omega)$) 6b,
and
- filtering said first spectrum of said exponential term ($f_e(\omega)$) 5b in said first Fourier transform for removing said first spectrum of the exponential term ($f_e(\omega)$) from said first Fourier transform and extracting the first spectrum of the useful signal ($f_p(\omega)$) 6b.

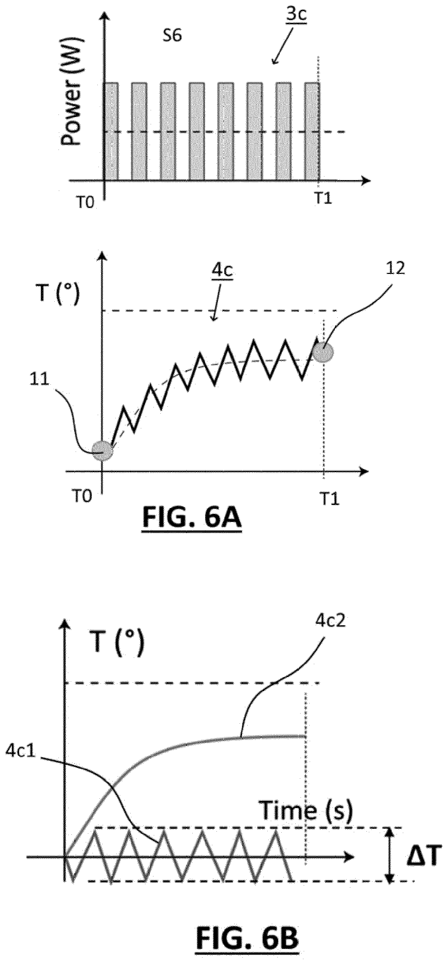

A third embodiment uses an excitation signal S6 3c that may be similar than signal S1 in the first embodiment but uses an interpolation over the time interval [T1 - T0] with starting temperature value 11 at T0 and temperature value 12 at T1 as shown in figure 6B to reconstruct the temperature rise 4c2 from the static part 4c1 of the excitation signal S6, or in other words, interpolation is made to reconstruct the quasi-exponential part of the temperature rise 4c2 having a spectrum 5c corresponding to the broadband noise spectrum of the signal T2 generated from its quasi-exponential part 4c2. Therefore, in the spectrum of T2, $f_p(\omega)$ is de-embedded from $f_p(\omega)$ by subtracting the spectrum of curve 4c2 from the one of curve 4c.

This embodiment presents the same advantages as the first embodiment: use of lock-in thermography in transient state resulting in reduction of acquisition time and SNR improvement, compared to measurement with constant power excitation.

This technique allows to apply efficiently lock-in at transient state and thus reducing measurement time compared to conventional lock-in applied in steady-state. Furthermore, the SPR is significantly improved compared to measurement using periodic excitation (in the presented example in annex 1, SPR is improved with a factor of 3.5 compared to measurement conventional lock-in, i.e., periodic excitation).

In this method is implemented

a. a reconstruction by interpolation of a non-periodic part of the bulk response signal 4c after provision of said first excitation signal 3c power modulated at a frequency $F_{lock}$ during a first period of time corresponding to a transient mode of said bulk response signal,

b. a calculation of a third Fourier transform $FT\{\Delta T(t)\}$ of said non-periodic part to provide a third spectrum of an exponential term ($f_e(\omega)$) 5c,

c. a subtraction of said third spectrum of said exponential term ($f_e(\omega)$) from said first spectrum of said exponential term ($f_e(\omega)$), said spectrum of a useful signal ($f_p(\omega)$) 6c and said first spectrum of ambient noise ($f_n(\omega)$) 7 in said first Fourier transform $FT\{\Delta T(t)\}$ for removing said first spectrum of the exponential term ($f_e(\omega)$) 5c from said first Fourier transform and extracting the first spectrum of the useful signal ($f_p(\omega)$) 6c.

In the present disclosure, filtering the ambient noise ($f_n(\omega)$) 7 may be done after extracting the useful signal or before in the time domain or in the frequency domain as known in the art.

Figure 8 shows a schematic view of an implementation system for the method disclosed, such system comprising:

- a target 100 which may be a 3D structure comprising at least one layer of a dielectric medium made of an organic or inorganic insulating material or semiconductor material, such target providing a bulk response signal 107 when subjected to an excitation signal 104 such as an electromagnetic or thermal excitation signal;

- an emitting device 102 source of the excitation signal 104 and in said source means 102a to modulate a power of said excitation signal at a frequency $F_{lock}$ and means 102b to modulate a power of said excitation signal with a non-periodic envelope. Said emitting device source of excitation signal may be for example a wireless communication device but may also be any device emitting an excitation signal such as microwave, mm-wave, IR or visible light generated by an electromagnetic source such as an EM power generator, a lamp, a laser or a heater. The excitation signal may also be a heat wave generated by a heat source driven by an electrical or mechanical force;

- sensor means 106 for acquiring said bulk response signal;

- analog to digital conversion means 108a connected to said sensor and computer means 108b configured to process said recording, reconstructing, calculating, and subtracting on digital data representative of bulk response signals converted by said analog to digital conversion means 108a and implementing the disclosed method. In the disclosed example, said target 100 is a test object subject to EM radiation of said wireless communication device 102, said sensor 106 is an IR sensor measuring intensity the IR radiation emitted by the target in response to the heat induced in said target subject to said EM radiation.

The system may also comprise communication means 105 between said source of excitation signal and said computer means for scheduling emission of said excitation signal and acquiring said bulk response signal.

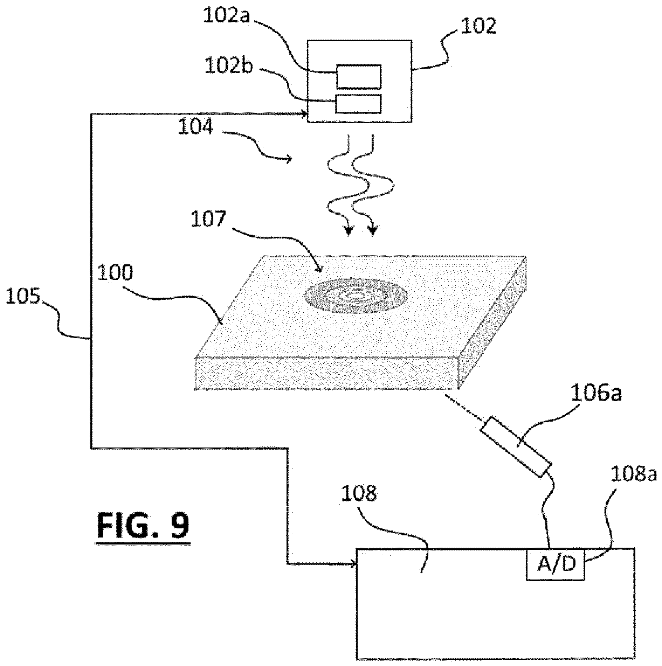

Figure 9 is an alternative design where a sensor 106a is located under the target and receives IR radiation emitted from the back side of the target. Such embodiment is the preferred embodiment related to the EM dosimetry where the response signal 107 is generated from the bottom surface of the target (i.e. opposite to the source position).

In other realization modes, the bulk response signal 107 is a time-variable physical quantity relative to the heat generated in the medium of the target when exposed to said excitation signal such as:

- an intensity of an IR radiation generated by said medium in response to said excitation signal, or
- an amplitude and/or frequency variation of an emitted or reflected EM radiation (e.g. visible light) by a material of the target such as a thermosensitive material, such as liquid crystal or a phase change material such as chalcogenide glass or vanadium dioxide in response to said excitation signal; or
- a voltage generated by a thermocouple attached or embedded in said medium of the target.

According to the disclosure a feature and advantage of the method is to stop emission of said excitation signal before a thermal steady state condition of the target is reached which is a novel method since in the prior art such steady state was awaited before starting the lock in method.

**Industrial application**

The proposed transient lock-in method can offer a great advantage for an hybrid EM/thermal dosimetry or characterization methods applied to various applications and, in particular, to the user exposure compliance testing of 5G/6G wireless devices operating at frequencies above 6GHz. Other applications are possible in measurements where a power source is used to expose a target and where the signal/noise ratio is low, including EM metrology for characterization of the antenna radiation characteristics and non-invasive material testing for possible defects, such as discontinuity of the target medium or inclusions of other media characterized by different EM and/or thermal properties.

**Claims**

1. - Method for retrieving a useful signal from a bulk response signal emitted by a target subjected to an excitation signal, comprising:

   - providing a first excitation signal (3a, 3b, 3c) at least modulated at a frequency $F_{lock}$ during a first period of time (t1) corresponding to a transient mode of a response signal and causing a first bulk response signal (4a, 4b, 4c) and recording said first bulk response signal,
   - calculating a first Fourier transform $FT\{\Delta T(t)\}$ (10a, 10b, 10c) of said bulk response signal in response to said first excitation signal during said first period to provide a first spectrum of an exponential term ($f_e(\omega)$) (5a, 5b, 5c) a first spectrum of ambient noise ($f_n(\omega)$) (7) and a first spectrum of a useful signal ($f_p(\omega)$) (6a, 6b, 6c) in said first measured bulk response signal,
   - extracting said first spectrum of a useful signal ($f_p(\omega)$) (6a, 6b, 6c) through removing said first spectrum of the exponential term ($f_e(\omega)$) (5a, 5b, 5c) from said first Fourier transform.

2. - Method according to claim 1 wherein said first excitation signal (3a) is followed with a further signal in a second period of time (t2, t3), said method comprising further:

   - providing said second period of time with a first sub-period of time (t2) where said further signal comprises a null excitation signal (32) value to let said bulk response signal end and a second sub period of time (t3) where said further signal comprises a constant power excitation signal (33) having a power value equal to the mean power of said first signal during said first period,

- calculating a second Fourier transform $FT\{\Delta T(t)\}$ (11a) of a second measured bulk response signal in response to said constant power excitation signal in said second sub-period to provide a second spectrum of said exponential term ($f_e(\omega)$), in said second measured bulk response signal,
- subtracting said second spectrum of said exponential term ($f_e(\omega)$) from said first spectrum of said exponential term ($f_e(\omega)$) in said first Fourier transform $FT\{\Delta T(t)\}$ for removing said first spectrum of the exponential term ($f_e(\omega)$) from said first Fourier transform and extracting the first spectrum of the useful signal ($f_p(\omega)$).

3. - Method according to claim 1 comprising further:

- modulating said first excitation signal with a non-periodic envelope (34) during said first period of time wherein said non-periodic envelope comprises a positive skew distribution during said first period of time, said positive skew distribution being adapted to have said bulk signal (4b) comprising a non-periodic Gaussian-like shape in order that said first spectrum of said exponential term ($f_e(\omega)$) (5b) does not overlap said third spectrum of said useful signal ($f_p(\omega)$) (6b),

and

- filtering said first spectrum of said exponential term ($f_e(\omega)$) (5b) in said first Fourier transform for removing said first spectrum of the exponential term ($f_e(\omega)$) from said first Fourier transform and extracting the first spectrum of the useful signal ($f_p(\omega)$) (6b).

4. - Method according to claim 1, comprising:

- reconstructing by interpolation of a non-periodic part of the bulk response signal (4c) after provision of said first excitation signal (3c) modulated at a frequency $F_{lock}$ during a first period of time corresponding to a transient mode of said bulk response signal,
- calculating a third Fourier transform $FT\{\Delta T(t)\}$ of said non-periodic part to provide a third spectrum of an exponential term ($f_e(\omega)$) (5c),
- subtracting said third spectrum of said exponential term ($f_e(\omega)$) from said first spectrum of said exponential term ($f_e(\omega)$), said spectrum of a useful signal ($f_p(\omega)$) (6c) in said first Fourier transform $FT\{\Delta T(t)\}$ for removing said first spectrum of the exponential term ($f_e(\omega)$) (5c) from said first Fourier transform and extracting the first spectrum of the useful signal ($f_p(\omega)$) (6c).

5. - Method according to any one of the preceding claims comprising an inverse Fourier transform to provide said useful signal ($f_p(\omega)$) after extracting the first spectrum of the useful signal ($f_p(\omega)$).

6. - Method according to claim 5 comprising a retrieval of a quantitative characteristic of the EM field incident on or absorbed by the target based on said useful signal and said first excitation signal.

7. - Method according to any one of the preceding claims wherein said excitation signal is one of electromagnetic waves such as microwave, mm-wave, IR, visible, or UV light generated by an electromagnetic source such as a wireless communication device, an EM power generator, a lamp, a laser or a heater or their combination.

8. - Method according to any one of the claims 1 to 6 wherein said excitation signal is a heat wave generated by a heat source driven by an electrical or mechanical force.

9. - Method according to any one of the preceding claims wherein said bulk response signal is a time-variable physical quantity relative to the heat generated by a medium of the target when exposed to said excitation signal such as:

- an intensity of an IR radiation generated by said medium in response to said excitation signal, or
- an amplitude and/or frequency variation of an emitted or reflected light by a material of the target such as a thermosensitive material, such as liquid crystal or a phase change material including chalcogenide glass or vanadium dioxide in response to said excitation signal; or
- a voltage generated by a thermocouple attached or embedded in said medium of the target.

**10.** - Method according to any one of the preceding claims wherein emission of said excitation signal is stopped before a thermal steady state condition (SS) of the target is reached.

**11.** - Method according to any one of the preceding claims comprising filtering the ambient noise ($f_n(\omega)$) (7) in the time or frequency domain to suppress the ambient noise from to useful signal ($f_p(\omega)$).

**12.** - System for performing the method of any one of the preceding claims comprising a source 102 of excitation signal 104, in said source means 102a to modulate a power of said excitation signal at a frequency $F_{lock}$, a target 100 providing a bulk response signal 107 when subjected to said excitation signal, sensor means (106, 106a) for acquiring said bulk response signal, analog to digital conversion means and computer means configured to process said recording, reconstructing, calculating and subtracting on digital data representative of bulk response signals converted by said analog to digital conversion means.

**13.** - System according to claim 12 wherein said source comprises means 102b to modulate a power of said excitation signal with a non-periodic envelope.

**14.** - System according to claim 12 or 13 wherein said target has a 3D structure comprising at least one layer of a dielectric medium made of an organic or inorganic insulating material or semiconductor material.

**15.** - System according to claim 12, 13 or 14 wherein said source of excitation signal is a wireless communication device and said target is a test object subject to EM radiation of said wireless communication device, said sensor is an IR sensor measuring intensity of the IR radiation, which is proportional to the temperature of the object being a source of this radiation.

**16.** - System according to any one of claims 12 to 15 comprising further communication means between said source of excitation signal and said computer means for scheduling emission of said excitation signal and acquiring said bulk response signal.

**FIG. 1A**

**FIG. 1B**

$f_p(\omega)$ $f_e(\omega)$

5

6

$f_p(F_{lock})$

$\dfrac{f_e(F_{lock})}{f_p(F_{lock})}$

$f_e(F_{lock})$

7

$f_n(\omega)$

$F_{lock}$

$F(Hz)$

**FIG. 1C**

$f_p(\omega)$

$f_e(\omega)$

51

6

7

$f_n(\omega)$

$F_{lock}$

$F(Hz)$

**FIG. 1D**

T (°)

8

Time (s)

**FIG. 1E**

**FIG. 2**

FIG. 3A

**FIG. 3B**

EP 4 354 158 A1

**FIG. 4A**

**FIG. 4B**

**FIG. 5A**

**FIG. 5B**

**FIG. 6A**

**FIG. 6B**

**FIG. 7**

EP 4 354 158 A1

**FIG. 8**

**FIG. 9**

Europäisches
Patentamt

European
Patent Office

Office européen
des brevets

# EUROPEAN SEARCH REPORT

Application Number

EP 22 30 6552

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SUNG QUEK ET AL: "A novel and robust thermal wave signal reconstruction technique for defect detection in lock-in thermography; A novel and robust thermal wave signal reconstruction technique for defect detection", MEASUREMENT SCIENCE AND TECHNOLOGY, IOP, BRISTOL, GB, vol. 16, no. 5, 1 May 2005 (2005-05-01), pages 1223-1233, XP020090607, ISSN: 0957-0233, DOI: 10.1088/0957-0233/16/5/024 | 1,5-16 | INV. G01R29/08 G01N25/72 |
| A | * page 1223, last paragraph - page 1232, last paragraph; figures 1-9 * ----- | 2-4 | |
| A | US 10 690 607 B2 (ADOLPHE MERKLE INSTITUTE UNIV OF FRIBOURG [CH]; NANOLOCKIN GMBH [CH]) 23 June 2020 (2020-06-23) * columns 6-14; claims 1-20; figures 1-8 * ----- | 1-16 | |
| A | US 11 039 089 B2 (INDIAN INSTITUTE OF TECH ROPAR [IN]) 15 June 2021 (2021-06-15) * columns 4-22; claims 1-14; figures 1-9 * ----- | 1-16 | TECHNICAL FIELDS SEARCHED (IPC) G01R G01N |
| A | CN 113 406 146 B (CHINA AERO POLYTECHNOLOGY ESTABLISHMENT) 22 February 2022 (2022-02-22) * the whole document * ----- | 1-16 | |

The present search report has been drawn up for all claims

| Place of search | Date of completion of the search | Examiner |
|---|---|---|
| Munich | 5 March 2023 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................................

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 22 30 6552

This annex lists the patent family members relating to the patent documents cited in the above-mentioned European search report.
The members are as contained in the European Patent Office EDP file on
The European Patent Office is in no way liable for these particulars which are merely given for the purpose of information.

05-03-2023

| Patent document cited in search report | | Publication date | Patent family member(s) | | Publication date |
|---|---|---|---|---|---|
| US 10690607 | B2 | 23-06-2020 | CA | 3022092 A1 | 09-11-2017 |
| | | | EP | 3452815 A1 | 13-03-2019 |
| | | | US | 2019154602 A1 | 23-05-2019 |
| | | | WO | 2017191129 A1 | 09-11-2017 |
| US 11039089 | B2 | 15-06-2021 | NONE | | |
| CN 113406146 | B | 22-02-2022 | NONE | | |

For more details about this annex : see Official Journal of the European Patent Office, No. 12/82

EPO FORM P0459